# EUROPÄISCHE PATENTSCHRIFT

(11) **EP 1 314 165 B1**
(45) Veröffentlichungstag und Bekanntmachung des Hinweises auf die Patenterteilung: **16.06.2004**
(21) Anmeldenummer: 01962977.3
(22) Anmeldetag: 28.08.2001
(51) Int. Cl.: G11C 11/16, G11C 11/15, G11C 11/02

(54) **SPEICHERZELLENANORDNUNG UND VERFAHREN ZU DEREN HERSTELLUNG**
MEMORY CELL ARRANGEMENT AND METHOD FOR THE PRODUCTION THEREOF
DISPOSITIF A CELLULES MEMOIRE ET SON PROCEDE DE REALISATION

(30) Priorität: 01.09.2000 DE 10043159
(43) Veröffentlichungstag der Anmeldung: 28.05.2003
(73) Patentinhaber: Infineon Technologies AG, 81669 München (DE)
(72) Erfinder: MIETHANER, Stefan, 93051 Regensburg (DE); SCHWARZL, Siegfried, 85579 Neubiberg (DE); SAENGER, Annette, 01099 Dresden (DE)
(74) Vertreter: Charles, Glyndwr
(86) Internationale Anmeldenummer: PCT/EP2001/009901
(87) Internationale Veröffentlichungsnummer: WO 2002/019338

(56) Entgegenhaltungen:
- WO-A-00/38191
- WO-A-00/52701
- US-A- 5 940 319

## Beschreibung

Die Erfindung betrifft eine Speicherzellenanordnung mit magnetoresistiven Speicherbauelementen sowie ein Verfahren zu deren Herstellung.

MRAM-Speicherbauelemente weisen ferromagnetische Schichten auf, wobei der Widerstand eines Speicherbauelementes von den Magnetisierungsrichtungen der ferromagnetischen Schichten abhängt. Bei paralleler Magnetisierung der ferromagnetischen Schichten ist der Widerstand des Speicherbauelementes klein, während bei einer antiparallelen Magnetisierung der ferromagnetischen Schichten der Widerstand des Speicherbauelementes groß ist.

Je nach Aufbau der Schichtstruktur des MRAM-Speicherbauelementes wird unterschieden zwischen einem GMR-Speicherbauelement und einem TMR-Speicherbauelement. Ein GMR-Speicherbauelement weist mindestens zwei ferromagnetische Schichten und eine dazwischen angeordnete nicht magnetische leitende Schicht auf, wobei das GMR-Speicherbauelement einen sogenannten GMR-Effekt (GMR: Giant Magnetoresistance) zeigt, bei dem der elektrische Widerstand des GMR-Speicherbauelementes davon abhängt, ob die Magnetisierungen in den beiden ferromagnetischen Schichten parallel oder antiparallel ausgerichtet sind.

Ein TMR-Speicherbauelement (TMR: Tunnelling Magnetoresistance) weist mindestens zwei ferromagnetische Schichten auf und eine dazwischen angeordnete isolierende nicht magnetische Schicht. Die isolierende Schicht ist dabei so dünn ausgebildet, dass es zu einem Tunnelstrom zwischen den beiden ferromagnetischen Schichten kommt. Die ferromagnetischen Schichten zeigen einen magnetoresistiven Effekt, der durch einen spinpolarisierten Tunnelstrom durch die zwischen den beiden ferromagnetischen Schichten angeordnete isolierende, nicht magnetische Schicht bewirkt wird. Der elektrische Widerstand des TMR-Speicherbauelementes hängt dabei davon ab, ob die Magnetisierungen der beiden ferromagnetischen Schichten parallel oder antiparallel ausgerichtet sind.

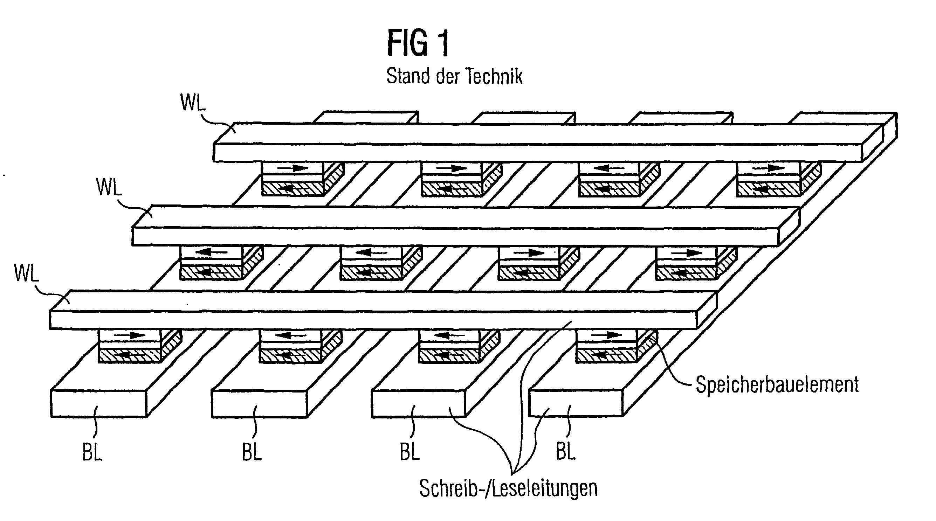

Figur 1 zeigt ein Speicherzellenfeld eines MRAM-Speichers nach dem Stand der Technik. Das Speicherzellenfeld weist eine Vielzahl von metallischen Schreib/Leseleitungen bzw. Wort- und Bitleitungen auf, die senkrecht zueinander verlaufend übereinander angeordnet sind und magnetoresistive Speicherbauelemente, die jeweils zwischen zwei sich kreuzenden Schreib/Leseleitungen liegen und mit diesen leitend verbunden sind. Signale, die an die Wortleitungen oder Bitleitungen angelegt werden, verursachen durch die hindurchfließenden Ströme Magnetfelder, die bei hinreichender Feldstärke die Speicherbauelemente beeinflussen. Gegenüber DRAM-Speichern zeichnen sich diese MRAM-Speicher dadurch aus, dass die einzelnen Speicherbauelemente keinen Auswahltransistor benötigen, sondern direkt an die Wort- und Bitleitungen angeschlossen werden können. MRAM-Speicher (MRAM: Magnetoresistant Random Access Memories) sind nicht flüchtige Lesespeicher mit sehr hohen Speicherdichten bzw. Speicherkapazitäten, die durch Übereinanderstapeln von mehreren Zellenfeldern, d.h. mehreren Lagen von Speicherbauelementen erzielt werden.

In der deutschen Patentanmeldung 199 085 18.8 (= WO-A-0 052 701) wird eine MRAM-Speicherzellenanordnung und ein Verfahren zu deren Herstellung beschrieben.

Eine Speicherzellenanordnung gemäß des Oberbegriffs des Anspruchs 1 ist aus WO-A-0 038 191 bekannt.

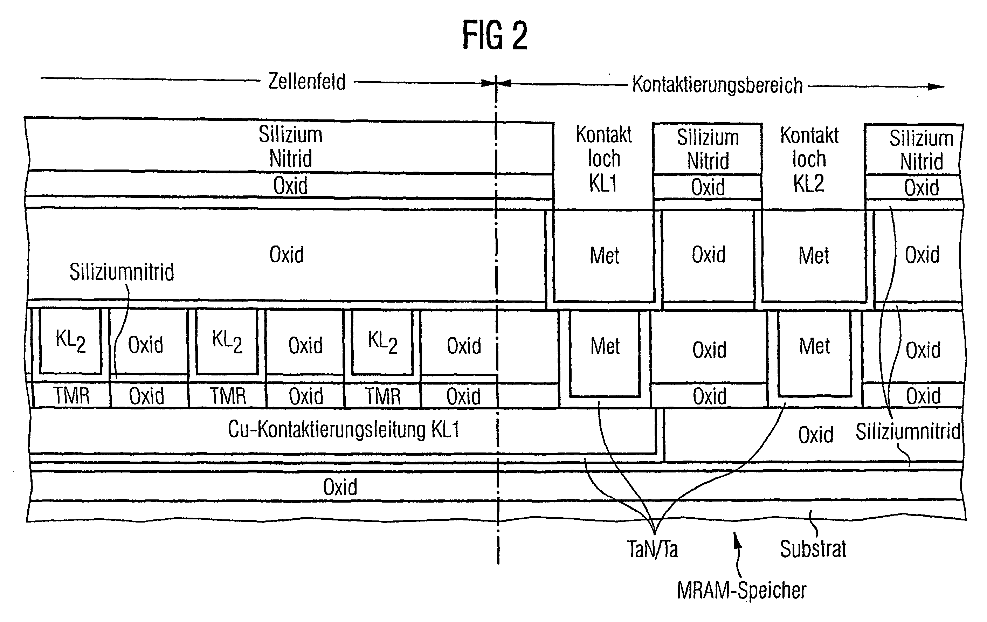

Figur 2 zeigt eine Querschnittsansicht durch eine derartige Speicherzellenanordnung nach dem Stand der Technik. Der MRAM-Speicher weist ein Zellenfeld und einen Kontaktierungsbereich bzw. einen Peripheriebereich zur Kontaktierung der in dem Zellenfeld enthaltenen Speicherbauelemente auf. In dem Speicherzellenfeld sind magnetoresistive Speicherbauelemente, beispielsweise TMR-Speicherbauelemente enthalten, die in einer Ebene rasterförmig angeordnet sind und die jeweils zwischen einer ersten Kontaktierungsleitung KL1 und einer zweiten Kontaktierungsleitung KL2 angeordnet sind. Die ersten Kontaktierungsleitungen KL1 verlaufen innerhalb einer dielektrischen Schicht, beispielsweise aus Siliziumdioxid. Die zweiten Kontaktierungsleitungen KL2 verlaufen ebenfalls innerhalb einer dielektrischen Schicht, beispielsweise aus Siliziumdioxid. Die Speicherbauelemente sind ebenfalls durch eine Oxidschicht voneinander elektrisch isoliert. Diese Oxidschicht hat eine direkte Verbindung mit der unteren Kontaktierungsleitung KL1. Die Kontaktierungsleitungen bestehen bei dem in Figur 2 dargestellten MRAM-Speicher im wesentlichen aus Kupfer.

Im Kontaktierungsbereich werden die Kontaktierungsleitungen über Kontaktlöcher kontaktiert. Die Kontaktlöcher sind über metallische Durchkontaktierungen mit den Kontaktierungsleitungen KL1, KL2 verbunden. Die aus Metall bestehenden Durchkontaktierungen weisen dabei eine Zwischenschicht bzw. einen Liner aus TaN/Ta als Haftschicht und Diffusionssperre auf. Auch die Kontaktleitungen KL1, KL2 weisen derartige TaN/Ta-Schichten bzw. Linerschichten auf. Die Kontaktierungsleitung KL1 weist ferner auf der Unterseite eine Siliziumnitridschicht auf, die als Diffusionsbarriere der Kupfer-Kontaktierungsleitung KL1 gegenüber der darunterliegenden O-xidschicht wirkt.

Der in Figur 2 dargestellte MRAM-Speicher nach dem Stand der Technik weist jedoch einige Nachteile auf. Die Kontaktierungsleitungen KL1 sind nicht vollständig mit Diffusionsbarriereschichten umhüllt bzw. eingekapselt. Die aus Kupfer bestehende Kontaktierungsleitung KL1 berührt direkt das darüberliegende aus Oxid bestehende Intermetalldielektrikum. Es kann daher zu einer Diffusion von Kupfer in das Intermetalldielektrikum kommen. Durch die Eindiffusion von Kupfer in das Intermetalldielektrikum bzw. die Oxidschicht wird die dielektrische Schicht degradiert und die Leitfähigkeit der dielektrischen Schicht nimmt zu. Darüber hinaus diffundieren Kupferatome seitlich in die Speicherelemente hinein und atomare Bestandteile der Speicherelemente (z.B. Fe, Co, Ni) aus den Speicherelementen in das Intermetalldielektrikum. Hierdurch entstehen Speicherdriften und im schlimmsten Fall kommt es zu einem vollständigen Ausfall des MRAM-Speichers.

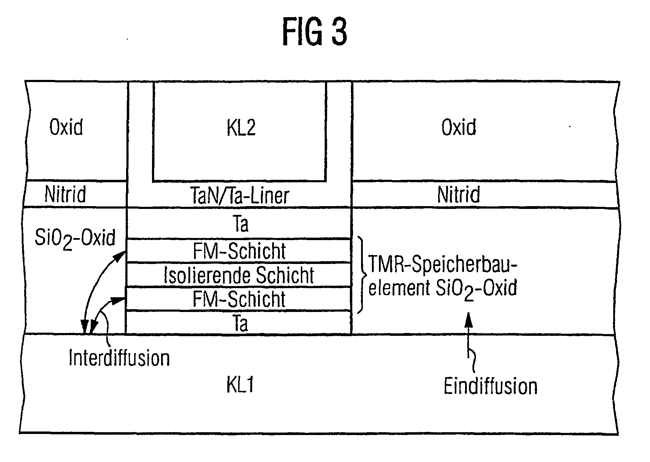

Figur 3 ist eine vergrößerte Ansicht eines Speicherbauelementes innerhalb des Zellenfeldes bei dem in Figur 2 dargestellten herkömmlichen MRAM-Speicher. Das magnetoresistive Speicherbauelement, beispielsweise ein TMR-Speicherbauelement, enthält mindestens zwei ferromagnetische Schichten (FM), die durch eine isolierende Schicht voneinander getrennt liegen. Ferner ist jeweils eine Tantalschicht zur Kontaktierung der beiden Kontaktierungsleitungen KL1, KL2 vorgesehen. Die Tantalschichten Ta bilden dabei Diffusionsbarrieren zwischen den ferromagnetischen Schichten (FM) und den aus Kupfer bestehenden Kontaktierungsleitungen KL.

Bei der herkömmlichen Speicherzellenanordnung besteht jedoch ein Nachteil darin, dass die ferromagnetischen Schichten (FM) und die erste aus Kupfer bestehende Kontaktierungsleitung KL1 an den Rändern der Speicherelemente lediglich durch eine dielektrische Oxidschicht voneinander getrennt liegen. Die ferromagnetischen Schichten enthalten Fe, Ni, Co, Cr, Mn, Gd und/oder Dy und besitzen typischerweise eine Dicke von 2 nm bis 20 nm. Auch die beiden Tantalschichten zur Kontaktierung des Speicherbauelementes sind relativ dünn, so dass die Abstände zwischen den beiden ferromagnetischen Schichten und den Kontaktierungsleitungen KL1 und KL2 relativ gering sind. Das Intermetalldielektrikum besteht aus Siliziumdioxid, das keine Diffusionsbarriere gegenüber Kupfer, welches in die ferromagnetischen Schichten diffundiert, und gegenüber Eisen, Nickel, Kobalt, Chrom, Mangan, Gd oder Dy, bildet, die von den ferromagnetischen Schichten (FM) in das Intermetalldielektrikum und die Kontaktierungsleitungen KL1 und KL2 diffundieren. Es kann daher zu einer schwerwiegenden Degradierung des Speicherbauelementes durch Eindiffusion von Kupfer kommen. Die Eindiffusion von Kupfer bewirkt Änderungen des magnetoresistiven Effektes und des Schaltverhaltens der Speicherbauelemente. Das aus Siliziumdioxid bestehende Intermetalldielektrikum, in dem die Speicherbauelemente eingebettet liegen, stellt weder für Kupfer noch für die in dem Speicherbauelement enthaltenen ferromagnetischen Elemente eine wirksame Diffusionsbarriere bei den bei der Speicherherstellung auftretenden Prozesstemperaturen zwischen 250 und 450°C dar.

Es ist daher eine Aufgabe der vorliegenden Erfindung, einen MRAM-Speicher und ein zugehöriges Herstellungsverfahren zu schaffen, dessen Speichereigenschaften durch Diffusionsvorgänge nicht verschlechtert werden.

Diese Aufgabe wird durch eine Speicherzellenanordnung mit den in Patentanspruch 1 angegebenen Merkmalen sowie durch ein Verfahren mit den in Patentanspruch 8 angegebenen Merkmalen gelöst.

Die Speicherbauelemente sind dabei vorzugsweise TMR-Speicherbauelemente, die jeweils zwei ferromagnetische Schichten und eine zwischen den beiden ferromagnetischen Schichten liegende isolierende nicht magnetische Schicht aufweisen.

Bei einer alternativen Ausführungsform der erfindungsgemäßen Speicherzellenanordnung sind die Speicherbauelemente GMR-Speicherbauelemente, die jeweils zwei ferromagnetische Schichten und eine zwischen den beiden ferromagnetischen Schichten liegende, leitende nicht magnetische Schicht aufweisen.

Die Speicherbauelemente sind vorzugsweise jeweils über Kontaktierungs-Diffusionsbarriereschichten an die Kontaktierungsleitungen angeschlossen.

Die Kontaktierungs-Diffusionsbarriereschichten bestehen dabei vorzugszweise aus Tantal.

Die zwischen der ersten Kontaktleitung und der zweiten dielektrischen Schicht vorgesehene Diffusionsbarriereschicht verhindert vorzugsweise zusätzlich eine Interdiffusion zwischen den Schichten der Speicherbauelemente und den ersten Kontaktierungsleitungen.

Bei einer bevorzugten Ausführungsform der erfindungsgemäßen Speicherzellenanordnung liegen die ersten Kontaktierungsleitungen durch eine zweite Diffusionsbarriereschicht von einer dritten dielektrischen Schicht getrennt, die auf einem Substrat angeordnet ist.

Bei einer besonders bevorzugten Ausführungsform der erfindungsgemäßen Speicheranordnung besteht die Diffusionsbarriereschicht aus Siliziumnitrid.

Die Kontaktierungsleitungen bestehen vorzugsweise im wesentlichen aus Kupfer.

Bei einer bevorzugten Ausführungsform bestehen die dielektrischen Schichten aus Siliziumdioxid.

Im weiteren werden bevorzugte Ausführungsformen des erfindungsgemäßen Herstellungsverfahrens zur Herstellung der erfindungsgemäßen Speicherzellenanordnung in Bezug auf die beigefügten Figuren zur Erläuterung erfindungswesentlicher Merkmale im Detail beschrieben.

Es zeigen:
- Figur 1: ein Speicherzellenfeld nach dem Stand der Technik;
- Figur 2: eine Schnittansicht durch einen MRAM-Speicher nach dem Stand der Technik;
- Figur 3: eine vergrößerte Schnittansicht eines Speicherbauelementes innerhalb des in Figur 2 dargestellten herkömmlichen MRAM-Speichers zur Erläuterung der der Erfindung zugrundeliegenden Problematik;
- Figuren 4a bis p: eine erste Prozessvariante zur Herstellung der erfindungsgemäßen Speicherzellenanordnung;
- Figuren 5a bis q: eine zweite Prozessvariante zur Herstellung der erfindungsgemäßen Speicherzellenanordnung;
- Figuren 6a bis p: eine dritte Prozessvariante zur Herstellung der erfindungsgemäßen Speicherzellenanordnung.

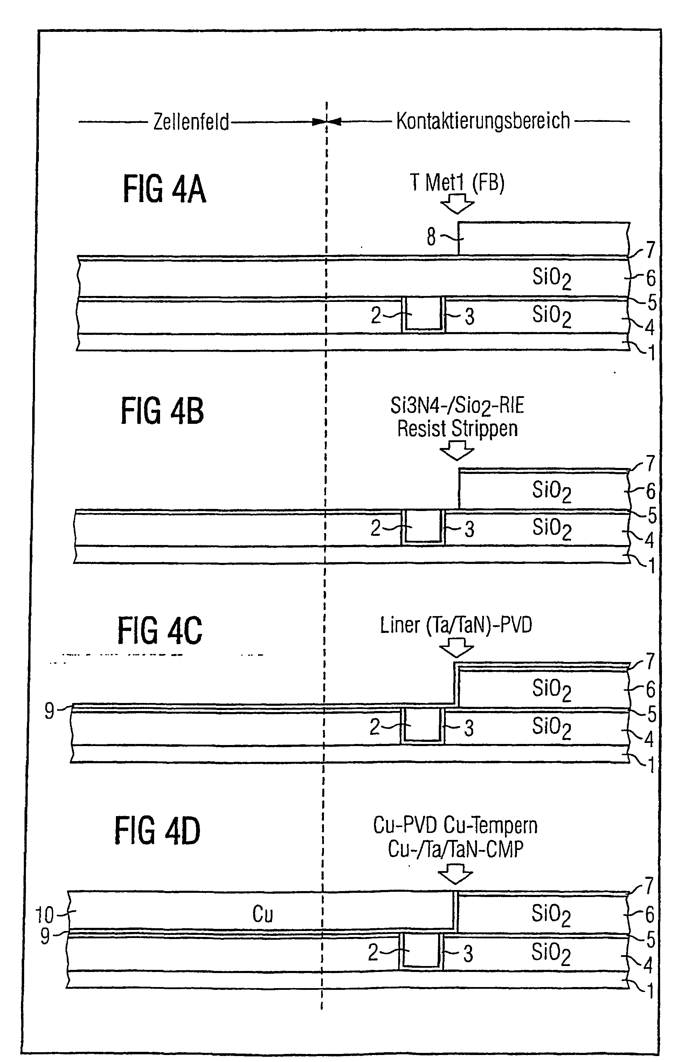

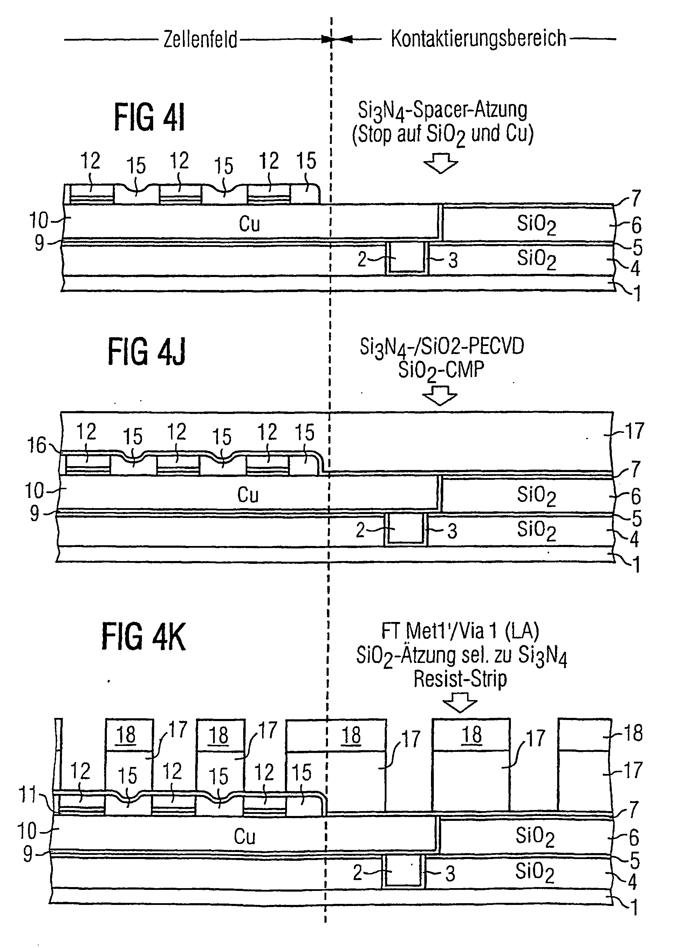

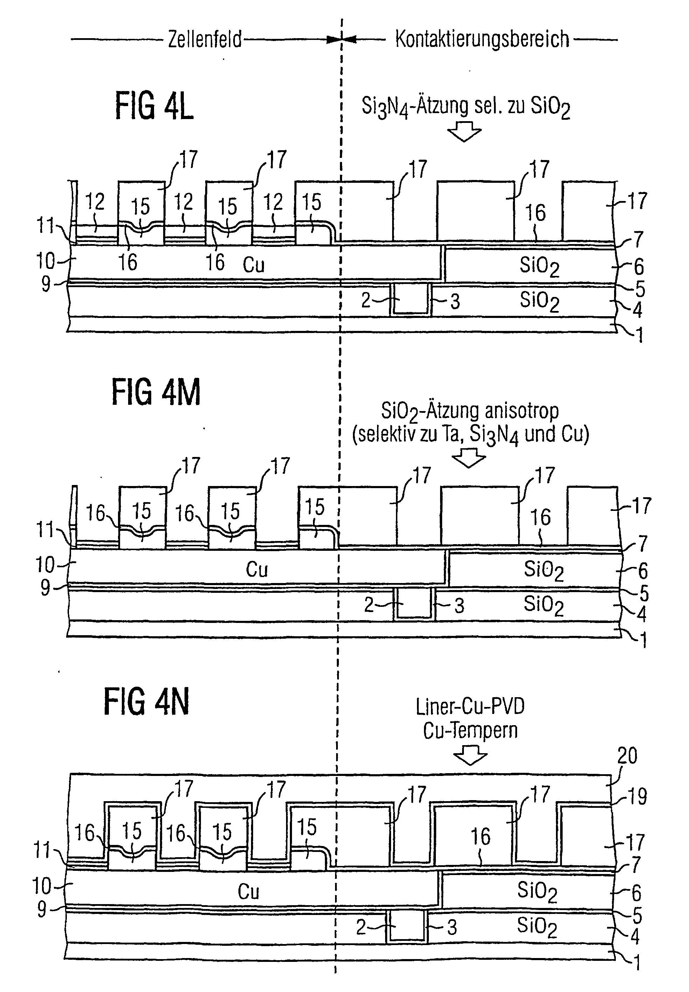

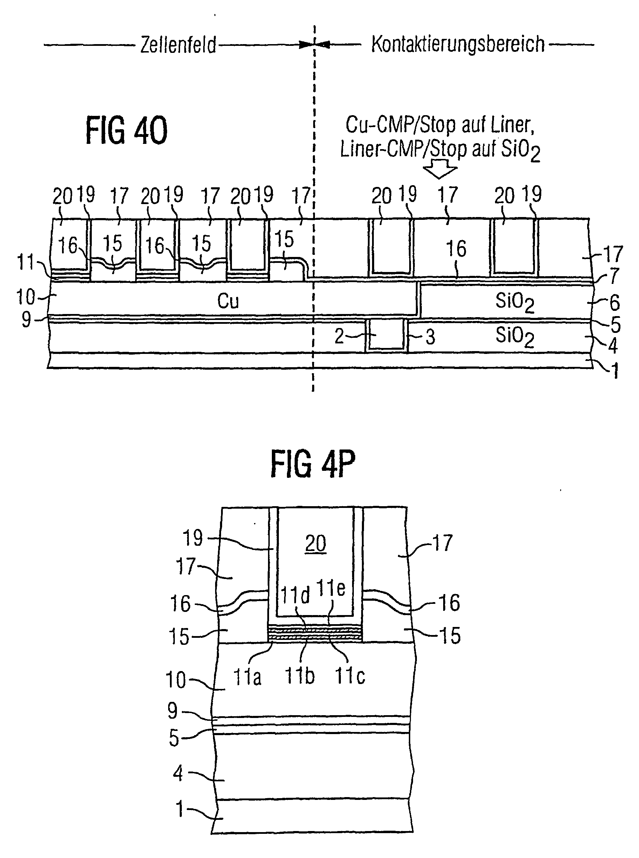

Im folgenden wird die erste Prozessvariante zur Herstellung der erfindungsgemäßen Speicherzellenanordnung unter Bezugnahme auf die Figuren 4a bis p im Detail beschrieben.

Ein Halbleitersubstrat, vorzugsweise Siliziumsubstrat, 1 enthält die integrierte CMOS- oder Bipolarelektronik (FEOL) und gegebenenfalls eine oder zwei Verdrahtungsebenen. Zur Kontaktierung der in dem Halbleitersubstrat 1 befindlichen Elektronik wird eine Durchkontaktierung bzw. ein Via 2 mit einer Liner-Schicht 3 in eine Siliziumdioxidschicht 4 gebildet, die das Halbleitersubstrat 1 überzieht. Eine erste Siliziumnitridschicht 5 dient als Ätzstoppschicht beim reaktiven Ionenätzen (RIE) des darüberliegenden Intermetalldielektrikums 6 und als Diffusionsbarierreschicht. Das Intermetalldielektrikum 6 besteht aus Siliziumdioxid. Eine weitere Siliziumnitridschicht 7 wird als Ätzstopp für eine nachfolgende Damascene-Ätzung vorgesehen. Die Siliziumnitridschicht 7 wird mit einer Lackmaske 8 im Kontaktierungsbereich überzogen und nach Durchführung fotolithografischer Schritte wird die Siliziumnitridschicht 7 und die Siliziumdioxidschicht 6 durch reaktives Ionenätzen RIE im Speicherzellenfeldbereich weggeätzt, wobei die Siliziumnitridschicht 5 als Ätzstoppschicht dient. Die Ätzung erfolgt anisotrop selektiv zu der unteren Siliziumnitridschicht 5.

Anschließend wird ein aus Ta/TaN bestehender Liner 9 durch PVD-Verfahren (PVD: Physical Vapour Deposition) abgeschieden. Zunächst wird eine Schicht aus TaN abgeschieden und anschließend eine Schicht aus Ta, die eine Ta/TaN-Doppelschicht bilden. Figur 4c zeigt den daraus resultierenden Prozesszustand.

In einem weiteren Prozessschritt wird Kupfer durch PVD-Verfahren abgeschieden. Da für die erfindungsgemäße MRAM-Speicherzellenanordnung nur Einzel-Damaszengräben mit kleinen Aspektverhältnissen unter 1 verwendet werden, genügt zu deren Auffüllung ein PVD-Verfahren (PVD: Physical Vapor Deposition). Das Aspektverhältnis gibt das Verhältnis zwischen der Höhe und der Breite eines Grabens an. Bei einer alternativen Ausführungsform wird Elektroplating eingesetzt. Das abgeschiedene Kupfer 10, das die ersten Kontaktierungsleitungen zur Kontaktierung der Speicherbauelemente bildet, wird anschließend getempert, um die physikalische Dichte zu erhöhen. Dies ist erforderlich, um Relaxationsprozesse des Kupfers, d.h. Aggregation von Mikrohohlräumen, vor den nachfolgenden chemisch-mechanischen Prozessschritten CMP abzuschließen, die sonst negative Auswirkungen auf die Qualität der polierten Kupferoberflächen und die Qualität der TMR-Speicherbauelemente haben würden. In nachfolgenden chemisch-mechanischen Polierschritten (CMP: Chemical Mechanical Polishing) wird überschüssiges Kupfer sowie die auf der Siliziumnitridschicht 7 liegende Liner-Schicht entfernt. Figur 4d zeigt den resultierenden Zustand. Der mehrstufige chemischmechanische Polierschritt CMP zum Entfernen von Kupfer und dem Liner-Material aus Ta/TaN wird durch die Siliziumnitridschicht 7 gestoppt. Die Rauhigkeit der polierten Kupferoberfläche der Kupferschicht 10 übersteigt dabei vorzugsweise nicht 4 bis 8 Angström.

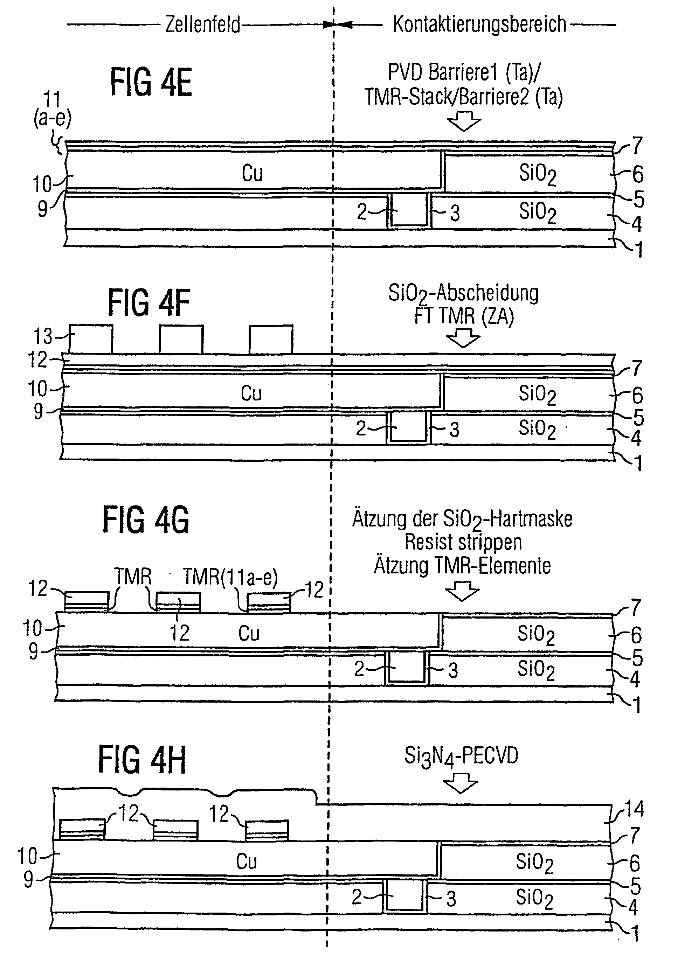

In weiteren Prozessschritten werden die Speicherelementschichten wie die Kontaktierungs-Diffusionsbarriereschichten aus Tantal ganzflächig abgeschieden. Figur 4e zeigt den daraus resultierenden Prozesszustand. Die Abscheidung sollte dabei innerhalb eines Vakuumsystems ohne Belüftung zwischen den einzelnen Abscheidungen erfolgen, d.h. PVD oder IBD. Die aufgebrachten fünf Speicherschichten werden in Figur 4e mit dem Bezugszeichen 11a bis 11e bezeichnet.

Anschließend wird eine Siliziumdioxidschicht 12 durch PECVD-Verfahren zur Erzeugung einer Hartmaske für die spätere Speicherbauelementstrukturierung auf der fünflagigen Speicherbauelementschicht 11a bis e abgeschieden. Die Hartmaske hat dabei etwa die doppelte bis dreifache Dicke wie die darunterliegende fünflagige Schicht. Die Hartmaske 12 aus Siliziumdioxid wird mit einer Resistmaske 13 geätzt. Die Hartmaske 12 ermöglicht steilere Flanken der TMR-Speicherbauelemente für die nachfolgende Spacerätzung, eine vollständige Auffüllung der TMR-Zwischenräume mit Siliziumnitrid, eine vollständige Einkapselung der Speicherbauelemente mit Diffusionsbarrieren sowie ein Lackveraschen durch O₂-Plasma vor dem Freilegen der Kupferleitungsbahnen, d.h. eine Vermeidung von Oxidation der Kupferleitungsbahnen. Nach durchgeführter Ätzung der Hartmaske 12 wird die Resist-Schicht 13 gestript bzw. entfernt. Schließlich erfolgt eine RIE-Ätzung zur Strukturierung der mehr-lagigen Speicherbauelemente selektiv zu der Hartmaske. Figur 4g zeigt den daraus resultierenden Prozesszustand.

Schließlich wird eine Siliziumnitridschicht mittels PE-CVD in einer Dicke abgeschieden, die ausreichend ist, die Zwischenräume zwischen den Speicherbauelementen 11a bis e vollständig auszufüllen. In Figur 4h erkennt man das abgeschiedene Siliziumnitrid 14.

In einem weiteren Schritt wird das abgeschiedene Siliziumnitrid anisotrop selektiv zu Siliziumdioxid und Kupfer zur Ausbildung von Spacern 15 geätzt. Die Spacer 15 bilden bei der gemäß der ersten Prozessvariante gebildeten Speicherzellenanordnung die späteren Diffusionsbarrieren. Über der in Figur 4i gezeigten resultierenden Struktur wird eine weitere ca. 50 nm dicke Siliziumnitridschicht 16 als Ätzstoppschicht für eine Damascene-Ätzung abgeschieden. Die Siliziumnitridschicht 16 wird durch eine weitere Siliziumdioxidschicht 17, die chemisch-mechanisch poliert wird, überzogen. Figur 4j zeigt die resultierende Struktur.

Es folgt eine anisotrope und zu dem Siliziumnitrid selektive Ätzung der Siliziumdioxidschicht 17 durch Plasmaätzen. Dabei wird eine Fotolackmaske 18 eingesetzt. Die Fotolackmaske 18 wird anschließend entfernt bzw. gestript.

In einem weiteren Prozessschritt wird die Siliziumnitridschicht 16 selektiv zu Siliziumdioxid und Kupfer mittels eines sanften niederenergetischen Prozesses geätzt, um ein Rücksputtern von Kupfer auf die Siliziumdioxidätzflanken zu minimieren. Figur 4ℓ zeigt den resultierenden Prozesszustand.

In einem weiteren Ätzschritt wird die Siliziumdioxidschicht 12, die auf den Speicherbauelementen liegt, vorzugsweise anisotrop weggeätzt. Diese Rückätzung ist ein selbstjustierender Ätzprozess, d.h. eine Ätzung erfolgt nur an denjenigen Stellen, an denen sich Speicherbauelemente 11 befinden. Durch die Rückätzung entstehen selbstjustierende Kontaktflächen zu den Speicherbauelementen 11. Figur 4m zeigt den resultierenden Prozesszustand. Die resultierenden Damascene-Strukturen werden durch Sputtern von Ta/TaN-Linern 19 und einer hinreichend dicken Kupferschicht 20 in einem PVD-Verfahren aufgefüllt. Das abgeschiedene Kupfer wird anschließend zur Erhöhung der physikalischen Dichte getempert. Figur 4n zeigt die resultierende Struktur.

Schließlich wird das abgeschiedene Kupfer und die abgeschiedene Linerschicht in einem zweistufigen chemisch-mechanischen Polierschritt (CMP) teilweise entfernt und es entsteht die in Figur 4o gezeigte Struktur.

Figur 4p zeigt eine Detailansicht eines Speicherbauelementes 11 innerhalb des Speicherzellenfeldes, wie es durch die erste Prozessvariante hergestellt wird. Das Speicherbauelement 11 besteht aus zwei ferromagnetischen Schichten 11b, 11d, die durch eine dazwischenliegende isolierende nicht magnetische Schicht 11c getrennt liegen. Zwischen der aus Kupfer bestehenden ersten Kontaktierungsleitung 10 und der aus Kupfer bestehenden zweiten Kontaktierungsleitung 20, die in einem Liner 19 liegt, und dem TMR-Speicherbauelement sind Kontaktierungs-Diffusionsbarriereschichten 11a, 11f aus Tantal vorgesehen. Das TMR-Speicherelement 11 mit den Kontaktierungs-Diffusionsbarriereschichten 11a, 11f ist vollständig durch die Diffusionsbarriereschicht 15 aus Siliziumnitrid umschlossen. Die Diffusionsbarriereschicht 15 trennt ferner die aus Kupfer bestehende Kontaktierungsleitung 10 von dem Intermetalldielektrikum 17 aus Siliziumdioxid. Die Diffusionsbarriereschicht unterbindet die Diffusion von Kupfer in das Intermetalldielektrikum 17. Ferner unterbindet die Diffusionsbarriereschicht 15 die Interdiffusion zwischen den ferromagnetischen Schichten 11b, 11c des Speicherbauelementes 11 und der ersten Kontaktierungsleitung 10. Es wird also sowohl eine Degradierung des Intermetalldielektrikums 17 als auch der Speicherbauelemente 11 aufgrund von Diffusion durch die Diffusionsbarriereschicht 15 verhindert.

In Fig. 4p wird der einfachste Schichtaufbau der Speicherbauelemente dargestellt. Nicht gezeichnet werden weitere Hilfsschichten zur Optimierung und Stabilisierung der magnetischen Eigenschaften.

Die in Figur 4o dargestellte Speicherzellenanordnung ist lediglich einlagig. Allerdings können mehrere Lagen von Speicherbauelementen 11 durch weitere Prozessschritte übereinandergelagert werden, so dass eine hohe Speicherkapazität des MRAM-Speichers erreicht werden kann. Derartige mehrlagige Speicherzellenfelder können durch eine Damascene-Mehrlagenverdrahtung kontaktiert werden.

Wie man aus Figur 4n erkennen kann, sind die ersten Kontaktierungsleitungen 10 vollständig durch Diffusionsbarriereschichten 5, 9, 15 eingekapselt. Dabei verhindern die Diffusionsbarriereschichten 5 aus Siliziumnitrid und 9 aus TaNiTa eine Diffusion von Kupfer in die darunterliegende dielektrische Schicht 4 aus Siliziumdioxid. Die Diffusionsbarriereschicht 15 verhindert im Bereich des Speicherzellenfeldes eine Eindiffusion von Kupfer in die Speicherbauelemente 11 und in die darüberliegende dielektrische Schicht 17, d.h. das Intermetalldielektrikum. Die ersten Kontaktleitungen 10 werden durch Via-Kontakte elektrisch kontaktiert. Die zweiten Kontaktierungsleitungen 20 werden durch Metallkontakte über (nicht gezeigte) Verbindungsleitungen, die die Via-Durchkontaktierungen umgehen, elektrisch angeschlossen.

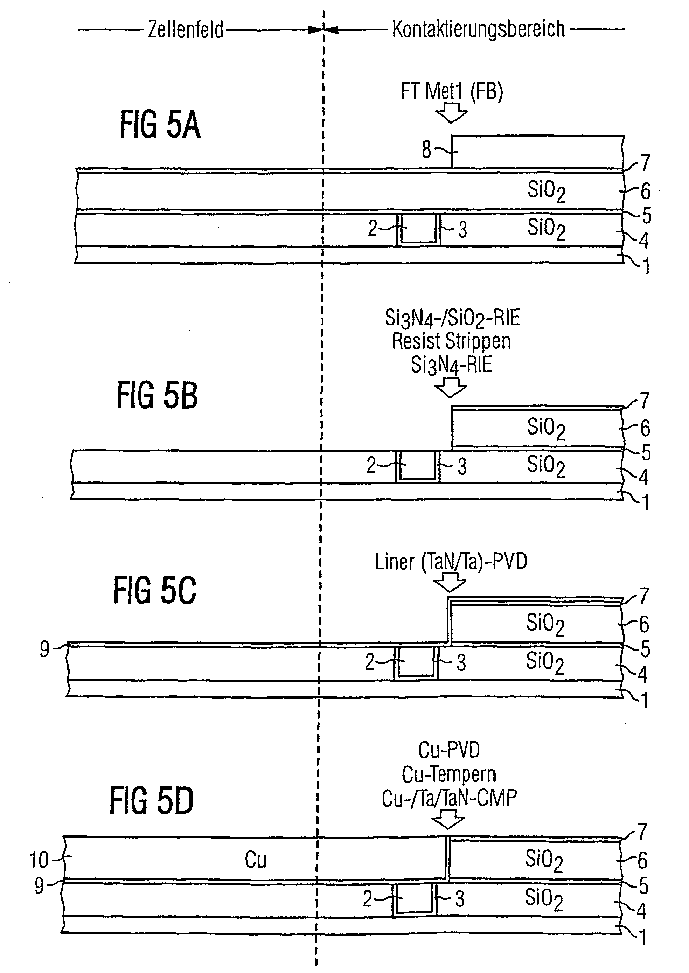

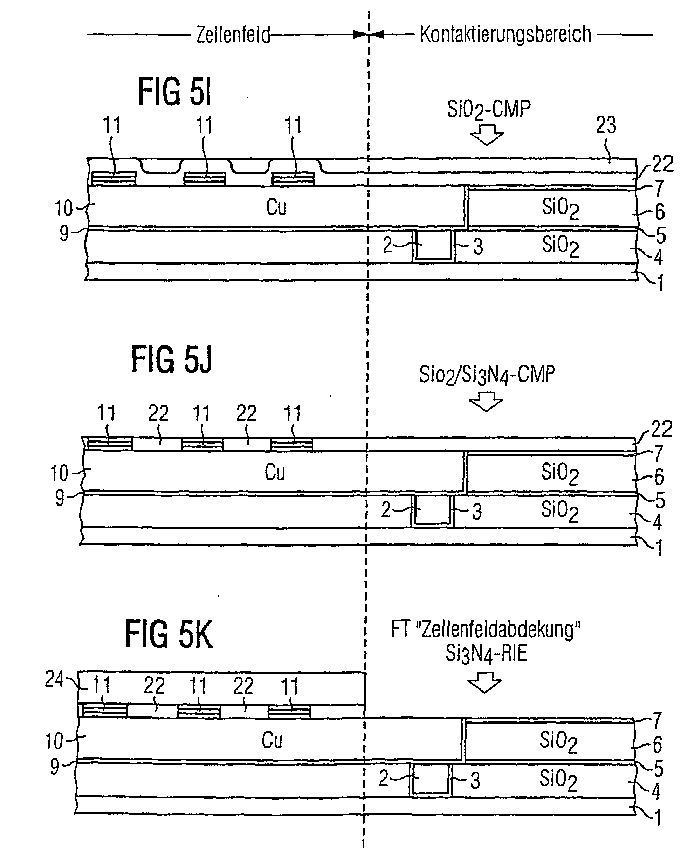

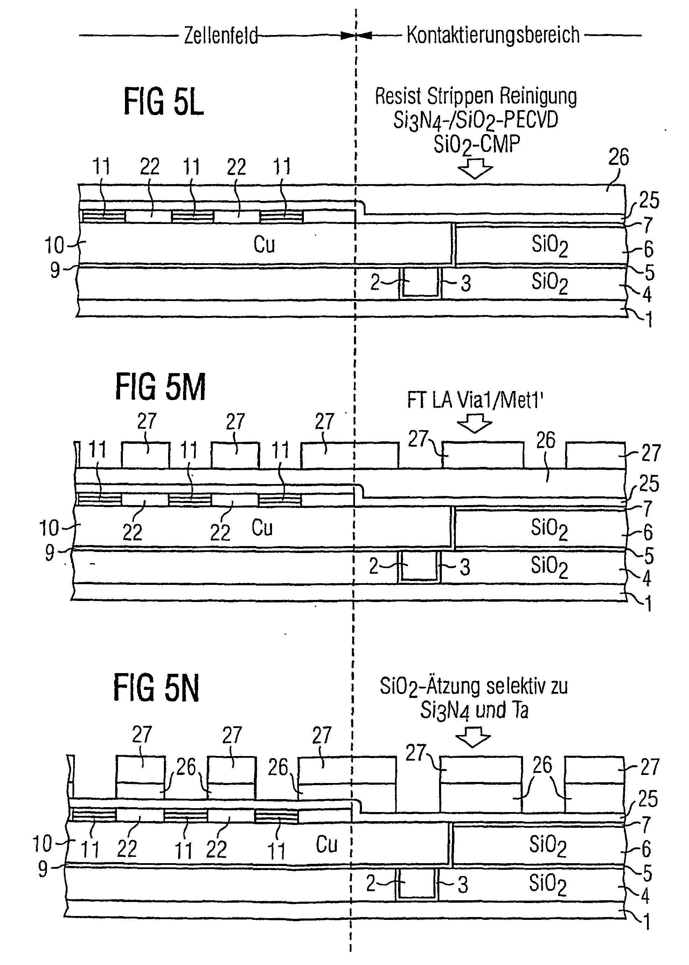

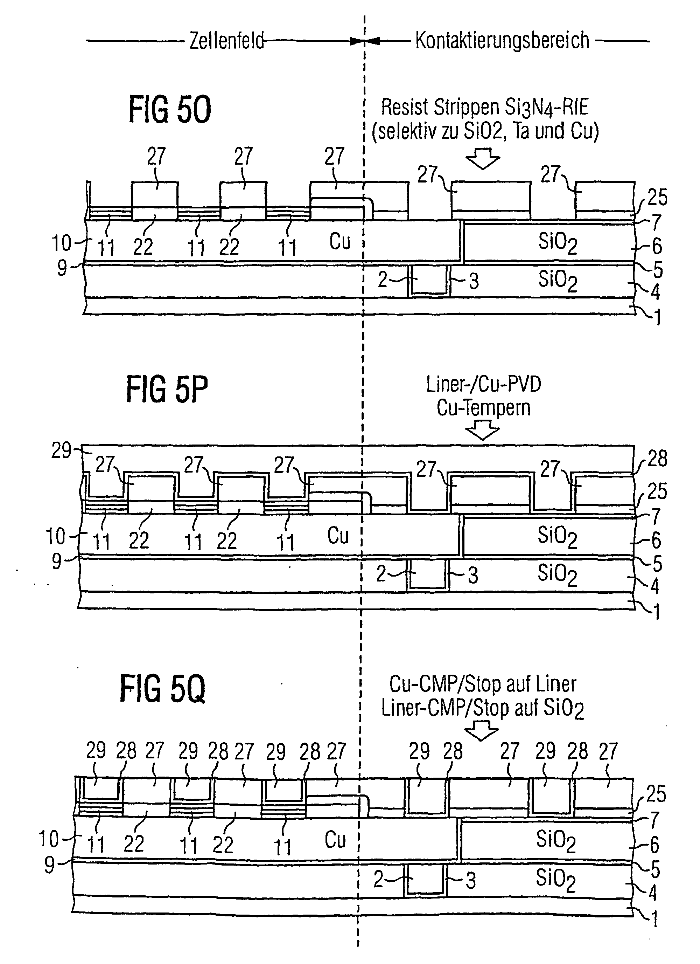

Die Figuren 5a bis g zeigen eine weitere Prozessvariante zur Herstellung der erfindungsgemäßen Speicherzellenanordnung. Die ersten Prozessschritte verlaufen wie bei der ersten Herstellungsvariante, die in den Figuren 4 dargestellt ist. Die Figuren 5a bis e entsprechen den Figuren 4a bis e der ersten Prozessvariante.

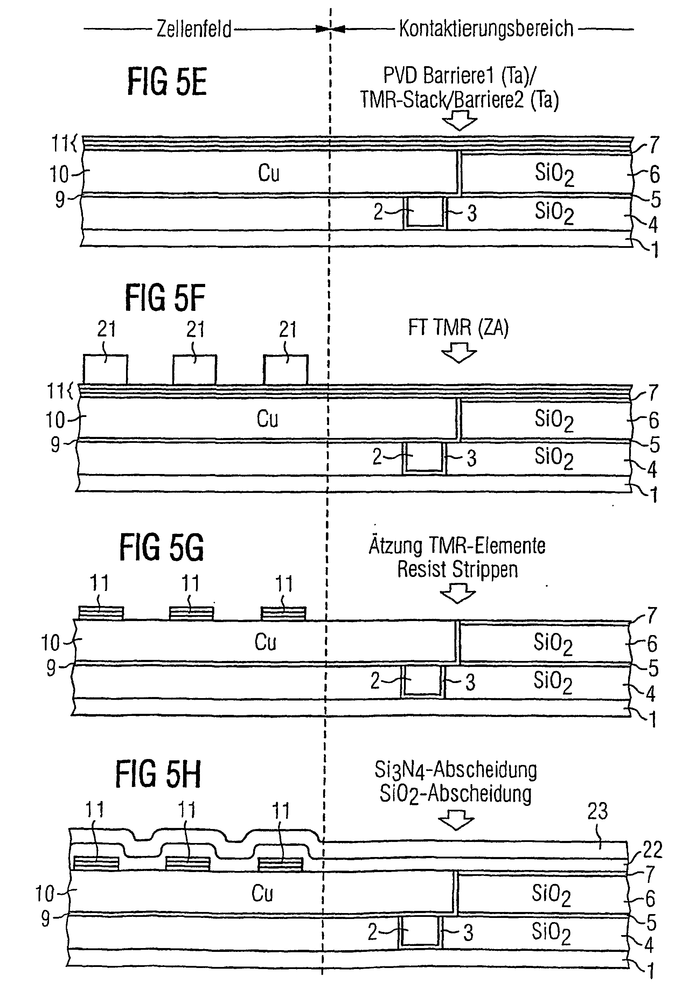

Wie in Figur 5f dargestellt, werden bei der zweiten Prozessvariante nach Aufbringen der Speicherbauelementschichten 11a -11e diese mittels einer Fotolackmaske 21 durch Ätzen strukturiert. Die Maske 21 wird anschließend mittels Strippen entfernt. Figur 5g zeigt den resultierenden Prozesszustand.

Über die in Figur 5g gezeigte Struktur wird daraufhin eine Siliziumnitridschicht 22 und eine Siliziumdioxidschicht 23 abgeschieden, wie man in Figur 5h erkennen kann.

Die beiden abgeschiedenen Schichten 22, 23 werden anschließend chemisch-mechanischen Polierschritten unterzogen, so dass die in Figur 5j dargestellte Struktur entsteht.

Das Speicherzellenfeld wird daraufhin mit einer Lackmaske 24 überzogen und die Siliziumnitridschicht 22 im Bereich der Speicherperipherie bzw. im Kontaktierungsbereich mittels RIE-Ätzen entfernt. Es entsteht die in Figur 5k dargestellte Struktur.

Die Fotolackmaske 24 wird entfernt und nach einem Reinigungsschritt wird zunächst eine Siliziumnitridschicht 25 und eine Siliziumdioxidschicht 26 mittels PECVD abgelagert. Die umliegende Siliziumdioxidschicht 26 wird mittels chemisch-mechanischen Polierens CMP geebnet und es entsteht die in Figur 5ℓ dargestellte Struktur.

Anschließend wird eine Fotolackmaske 27 auf die Siliziumdioxidschicht 26 aufgebracht und strukturiert. Es entsteht die in Figur 5m dargestellte Struktur.

In einem weiteren Prozessschritt wird die Siliziumdioxidschicht 26 selektiv zu Siliziumnitrid und Ta geätzt. Figur 5n zeigt die resultierende Anordnung.

Schließlich wird die Fotolackmaske 27 wiederum entfernt und die Siliziumnitridschicht 25 selektiv zu Siliziumdioxid, Tantal und Kupfer mittels RIE-Ätzens in den freiliegenden Bereichen entfernt. Hierdurch werden die Speicherbauelemente 11 im Speicherzellenfeld sowie Anschlüsse für die Kontaktleitungen 10 freigelegt. Die in Figur o gezeigte Struktur wird zunächst mit einer Linerschicht 28 und anschließend mit einer Kupferschicht 29 mittels PVD-Verfahren überzogen. Die Kupferschicht 29 wird anschließend getempert. Figur 5p zeigt die resultierende Struktur.

In einem weiteren Schritt wird das überschüssige Kupfer in einem chemisch-mechanischen Polierschritt CMP mit Stop auf der Linerschicht 28 entfernt. Schließlich wird die Linerschicht 28 in einem weiteren chemisch-mechanischen Polierschritt CMP mit Stop auf der Siliziumdioxidschicht 17 entfernt und es entsteht die in Figur 5q dargestellte Struktur.

Wie man aus Figur 5q erkennen kann, liegen die ersten Kontaktierungsleitungen 10 durch die Diffusionsbarriereschicht 22 aus Siliziumnitrid von dem Intermetalldielektrikum 27, das aus Siliziumdioxid besteht, getrennt, so dass keine Diffusion von Kupfer in das Dielektrikum 27 auftreten kann. Ferner verhindert die Diffusionsbarriereschicht 22 eine Interdiffusion zwischen den Schichten der Speicherbauelemente 11 und den Kontaktierungsleitungen 10.

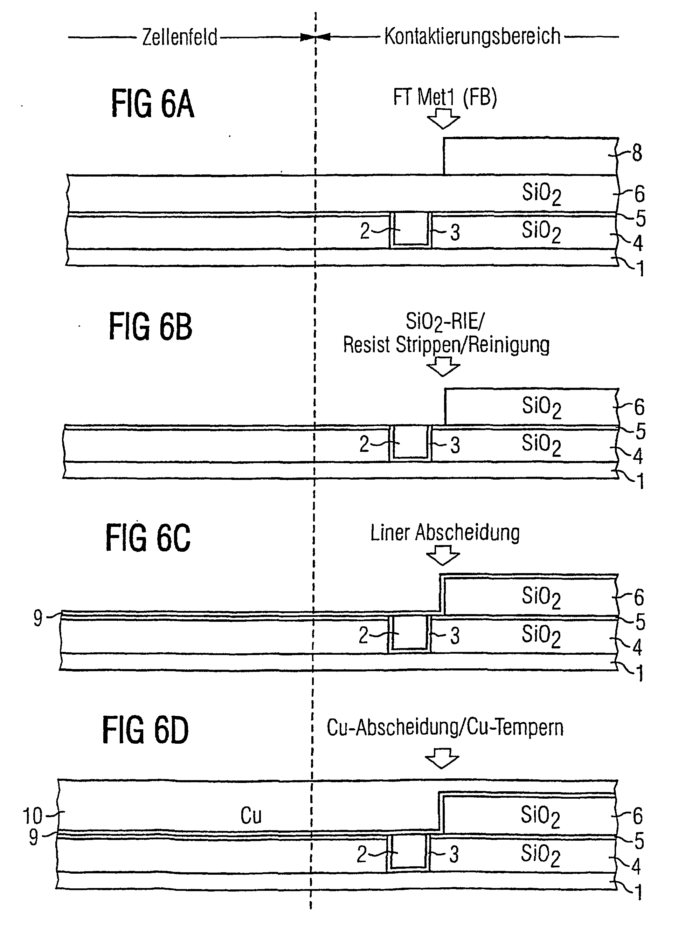

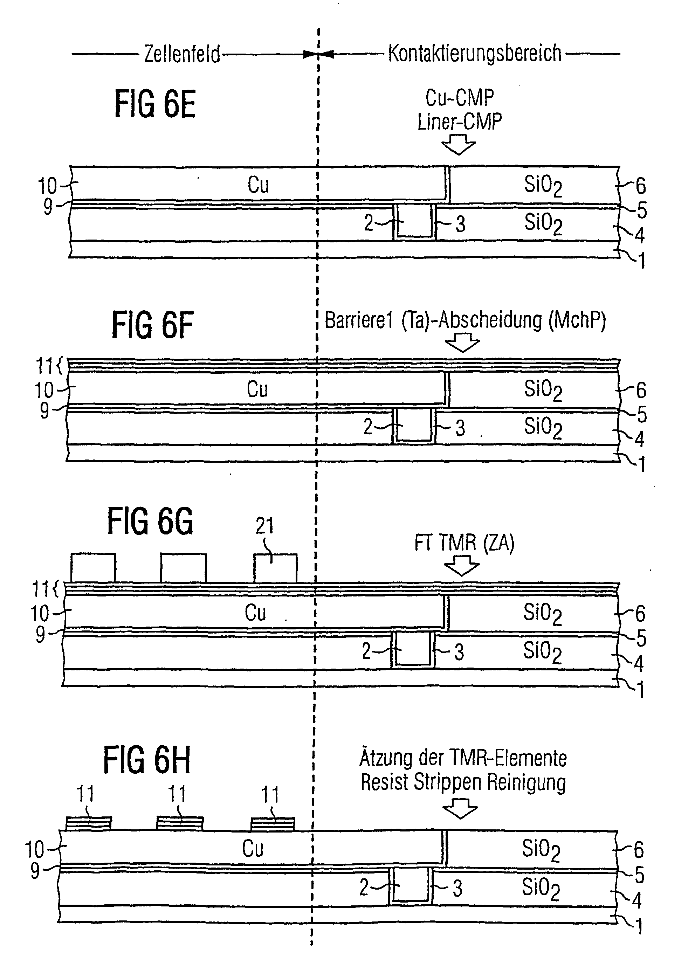

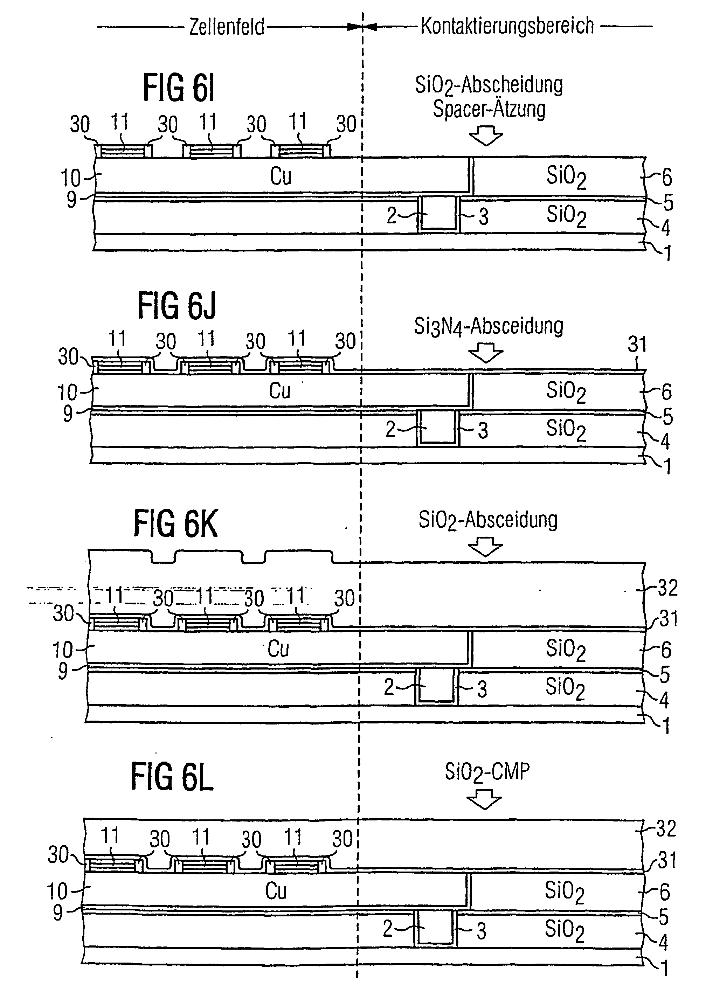

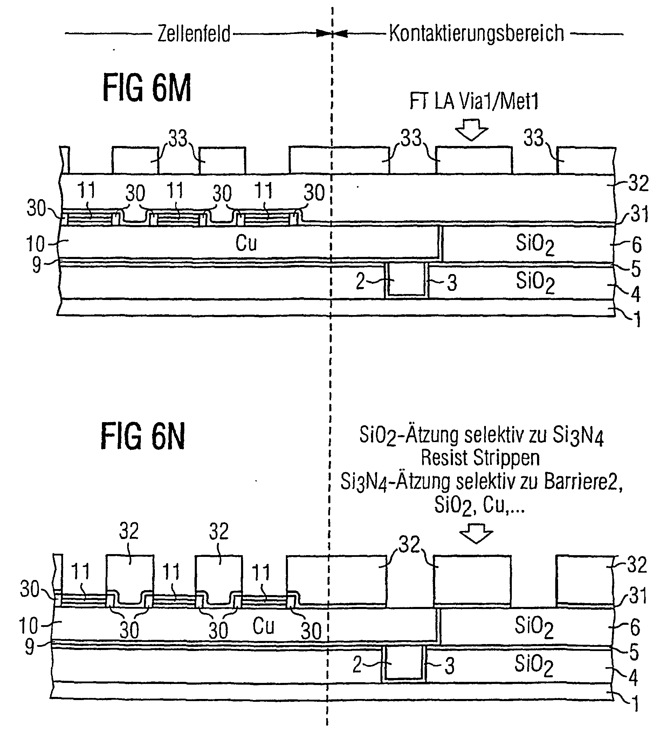

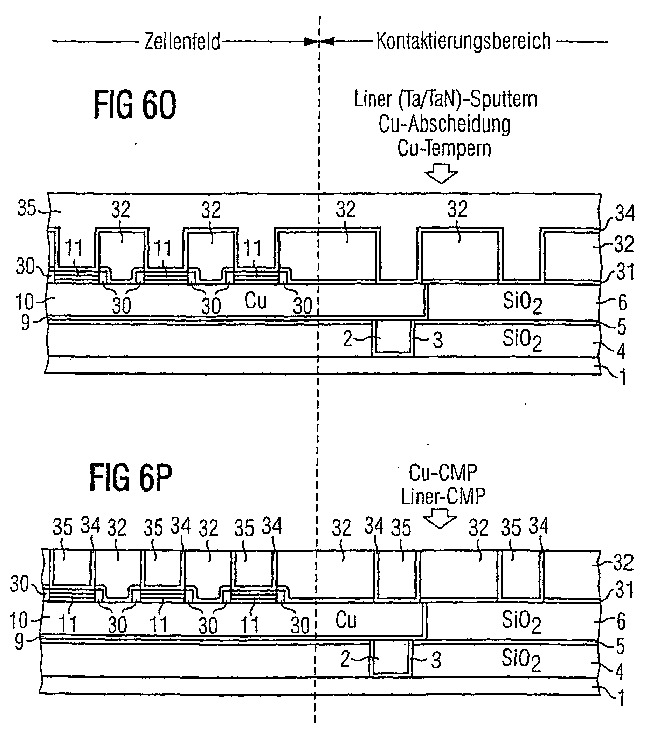

Die Figuren 6a bis n zeigen eine dritte Prozessvariante zur Herstellung der erfindungsgemäßen Speicherzellenanordnung. Dabei stimmen die ersten Prozessschritte mit den beiden in den Figuren 4 und 5 dargestellten Prozessen überein. Die Figuren 6a bis f entsprechen den Figuren 4a bis e und den Figuren 5a bis e der beiden bereits beschriebenen Prozessvarianten. Die Figuren 6g und h entsprechen den in den Figuren 5f und g bezeichneten Prozessschritten der zweiten Prozessvariante.

Wie in Figur 6i zu erkennen, wird bei der dritten Prozessvariante zur Herstellung der erfindungsgemäßen Speicherzellenanordnung auf den strukturierten Speicherbauelementen 11 eine Siliziumdioxidschicht abgeschieden und anschließend mittels eines anisotropen Ätzschrittes ohne Fotomaske zur Bildung von Spacern 30 zurückgeätzt, die die Speicherbauelemente 11 umschließen.

In einem weiteren Schritt wird eine Siliziumnitridschicht 31 abgeschieden und es entsteht die in Figur 6j gezeigte Struktur.

Daraufhin wird eine Siliziumdioxidschicht 32 abgeschieden und chemisch-mechanisch poliert, so dass die in Figur 6ℓ dargestellte Struktur entsteht.

Auf der glatten Siliziumdioxidschicht 32 wird eine Fotomaske 33 aufgebracht und die Siliziumdioxidschicht 32 selektiv mittels der Fotomaske 33 geätzt. Die Fotolackmaske 33 wird anschließend entfernt. Schließlich wird in einem weiteren Ätzschritt eine Siliziumnitridätzung selektiv zu Siliziumdioxid und Kupfer durchgeführt, so dass die in Figur 6n dargestellte Struktur entsteht.

Die Struktur wird schließlich mit einer Liner-Doppelschicht aus Ta/TaN mittels Sputtern überzogen, die mit Kupfer überdeckt wird, das anschließend getempert wird. Schließlich wird die Kupferschicht 35 und die darunterliegende Linerschicht 34 mittels chemisch-mechanischen Polierens entfernt, so dass die in Figur 6p dargestellte Struktur entsteht.

Wie man aus Figur 6p erkennen kann, sind die Kontaktierungsleitungen 10 aus Kupfer von der darüberliegenden Intermetallschicht 32 durch eine Diffusionsbarriereschicht 7 getrennt, die eine Eindiffusion von Kupfer in die dielektrische Schicht 32 verhindert. Durch eine Diffusionsbarriereschicht 5 und den Liner 9 wird ferner eine Eindiffusion von Kupfer in die dielektrische Schicht 4 verhindert.

Die gemäß der Prozessvariante 3 dargestellte Speicherzellenanordnung hat gegenüber Speicherzellenanordnungen, die nach den beiden ersten Prozessvarianten, wie sie in den Figuren 5 und 6 dargestellt sind, hergestellt wurden, den Nachteil, dass die Oxid-Spacer 30 eine Interdiffusion zwischen den Speicherbauelementen und der ersten Kontaktierungsleitung 10 nicht verhindern. Dafür hat die dritte Prozessvariante gemäß der Figur 6 im Vergleich zur Prozessvariante 2 den Vorteil, dass es sich um einen relativ einfachen Herstellungsprozess handelt, der keine kritischen CMP-Prozessschritte enthält und keine Hilfsmaske zum Schutz des Speicherelementzellenfeldes während der Siliziumnitridzurückätzung in der Peripherie (Fig. 5k) benötigt.

Die im Zusammenhang mit der Figur 4 beschriebene erste Prozessvariante bietet neben der Verhinderung von Diffusionen weitere Vorteile. Es ist keine lithografische Hilfsmaske erforderlich, die sicherstellt, dass während der Via-Ätzung in der Peripherie und der Grabenätzung für die oberen Leitungen im Speicherzellenfeld die Seitenflanken der Speicherbauelemente 11 nicht freigelegt und durch die anschließenden Metallabscheidungen kurzgeschlossen werden. Der Ätzprozess zur Freilegung der Speicherbauelemente ist vielmehr selbstjustierend. Bei der Siliziumdioxidgrabenätzung wird mittels einer Ätzstopschicht aus Siliziumnitrid verhindert, dass unreproduzierbare Ätztiefen und Leiterbahnwiderstände hervorgerufen werden. Ferner wird verhindert, dass während der Siliziumdioxidgrabenätzung Kupfer auf die Siliziumdioxidflanken der Vias und Gräben redeponiert wird und in des Intermetalldieelektrikum sowie in die Speicherbauelemente eindiffundieren kann.

Ferner wird durch alle erfindungsgemäßen Prozessvarianten verhindert, dass durch Resiststrippen nach der Grabenätzung freiliegendes Kupfer durch den O₂-haltigen Standardplasmaprozess oxidiert wird. Hierdurch können Reinigungsschritte zur Entfernung korrodierter Kupferoberflächen eingespart werden.

## Patentansprüche

1. Speicherzellenanordnung mit
einem Speicherzellenfeld, das mindestens eine Lage von magnetoresistiven Speicherbauelementen (11) mit mindestens zwei ferromagnetischen Schichten aufweist,
die jeweils an ersten Kontaktierungsleitungen (10) angeschlossen sind, wobei die ersten Kontaktierungsleitungen (10) aus Kupfer bestehen und innerhalb einer ersten dielektrischen Schicht (6) liegen, und
die jeweils an zweite Kontaktierungsleitungen (20; 29; 35) angeschlossen sind, wobei die zweiten Kontaktierungsleitungen (20; 29; 35) aus Kupfer bestehen und innerhalb einer zweiten dielektrischen Schicht (17; 27; 32) liegen,
**dadurch gekennzeichnet,**
**dass** eine Diffusionsbarriereschicht (15; 22; 7; 31) aus Siliziumnitrid, welche die Speicherbauelemente (11) anliegend umschließt, zwischen den ersten Kontaktierungsleitungen (10) und der zweiten dielektrischen Schicht (17; 27; 32) vorgesehen ist,
wobei die Diffusionsbarriereschicht (15; 22; 7; 31) die Eindiffusion von Kupfer aus den ersten Kontäktierungsleitungen (10) in die zweite dielektrische Schicht (17; 27; 32) und in die magnetoresistiven Speicherbauelemente (11) unterbindet und
wobei die Diffusionsbarriereschicht (15; 22; 7; 31) die Interdiffusion zwischen den ferromagnetischen Schichten (11b, 11d) der magnetoresistiven Speicherbauelemente (11) und den ersten Kontaktierungsleitungen (10) zur Minimierung von Speicherdrift unterbindet.

2. Speicherzellenanordnung nach Anspruch 1,
**dadurch gekennzeichnet,**
**dass** die Speicherbauelemente (11) TMR-Speicherbauelemente sind, die jeweils zwei ferromagnetische Schichten (11b, 11d) und eine zwischen den beiden ferromagnetischen Schichten (11b, 11d) liegende isolierende nicht magnetische Schicht (11c) aufweisen.

3. Speicherzellenanordnung nach Anspruch 1,
**dadurch gekennzeichnet,**
**dass** die Speicherbauelemente (11) GMR-Speicherbauelemente sind, die jeweils zwei ferromagnetische Schichten (11b, 11d) und eine zwischen den beiden ferromagnetischen Schichten (11b, 11d) liegende leitende nicht magnetische Schicht (11c) aufweisen.

4. Speicherzellenanordnung nach einem der vorangehenden Ansprüche,
**dadurch gekennzeichnet,**
**dass** die Speicherbauelemente (11) jeweils über Kontaktierungs-Diffusionsbarriereschichten (11a, 11e) an die Kontaktierungsleitungen (10; 20; 29; 35) angeschlossen sind.

5. Speicherzellenanordnung nach einem der vorangehenden Ansprüche,
**dadurch gekennzeichnet,**
**dass** die Kontaktierungs-Diffusionsbarriereschichten (12a, 11e) aus Tantal bestehen.

6. Speicherzellenanordnung nach einem der vorangehenden Ansprüche,
**dadurch gekennzeichnet,**
**dass** die ersten Kontaktierungsleitungen (10) durch eine zweite Diffusionsbarriereschicht (5) und einen Liner (9) von einer dritten dielektrischen Schicht (4) getrennt werden, die auf einem Halbleitersubstrat (1) angeordnet ist.

7. Speicheranordnung nach einem der vorangehenden Ansprüche,
**dadurch gekennzeichnet,**
**dass** die dielektrischen Schichten aus Siliziumdioxid bestehen.

8. Verfahren zur Herstellung einer Speicherzellenanordnung nach Anspruch 1 mit den folgenden Schritten:
(a) Abscheiden und Strukturieren der ersten Kontaktierungsleitungen (10) in der ersten dielektrischen Schicht (6) in einem Speicherzellenfeld eines Halbleitersubstrats;
(b) Abscheiden und Strukturieren der magnetoresistiven Speicherbauelemente (11) in dem Speicherzellenfeld;
(c) Abscheiden und Strukturieren der Diffusionsbarriereschicht (15; 22, 7) in dem Speicherzellenfeld;
(d) selbstjustierte Kontaktierung der Speicherbauelemente (11) durch Rückätzen der Hartmaske (12), durch die die Strukturierung der Speicherbauelemente (11) definiert wird.
(e) Abscheiden und Strukturieren der zweiten Kontaktierungsleitungen (20, 29, 35) in der zweiten dielektrischen Schicht (17, 27, 32) in dem Speicherzellenfeld.

## Claims

1. Memory cell arrangement, having
a memory cell array which has at least one layer of magnetoresistive memory components (11) with at least two ferromagnetic layers,
which are each connected to first contact-making lines (10), the first contact-making lines (10) consisting of copper and lying within a first dielectric layer (6), and
which are each connected to second contact-making lines (20; 29; 35), the second contact-making lines (20; 29; 35) consisting of coppper and lying within a second dielectric layer (17; 27; 32),
**characterized in that** a diffusion barrier layer (15; 22; 7; 31) of silicon nitride, which surrounds and bears against the memory components (11), is provided between the first contact-making lines (10) and the second dielectric layer (17; 27; 32),
the diffusion barrier layer (15; 22; 7; 31) suppressing the diffusion of copper out of the first contact-making lines (10) into the second dielectric layer (17; 27; 32) and into the magnetoresistive memory components (11), and
the diffusion barrier layer (15; 22; 7; 31) suppressing the interdiffusion between the ferromagnetic layers (11b, 11d) of the magnetoresistive memory components (11) and the first contact-making lines (10) in order to minimize memory drift.

2. Memory cell arrangement according to Claim 1, **characterized in that** the memory components (11) are TMR memory components which each have two ferromagnetic layers (11b, 11d) and an insulating nonmagnetic layer (11c) which lies between the two ferromagnetic layers (11b, 11d).

3. Memory cell arrangement according to Claim 1, **characterized in that** the memory components (11) are GMR memory components which each have two ferromagnetic layers (11b, 11d) and a conductive nonmagnetic layer (11c) which lies between the two ferromagnetic layers (11b, 11d).

4. Memory cell arrangement according to one of the preceding claims, **characterized in that** the memory components (11) are each connected to the contact-making lines (10; 20; 29; 35) via contact-making diffusion barrier layers (11a, 11e).

5. Memory cell arrangement according to one of the preceding claims, **characterized in that** the contact-making diffusion barrier layers (11a, 11e) consist of tantalum.

6. Memory cell arrangement according to one of the preceding claims, **characterized in that** the first contact-making lines (10) are separated from a third dielectric layer (4), which is arranged on a semiconductor substrate (1), by a second diffusion barrier layer (5) and a liner (9).

7. Memory arrangement according to one of the preceding claims, **characterized in that** the dielectric layers consist of silicon dioxide.

8. Method for fabricating a memory cell arrangement according to claim 1, comprising the following steps:
(a) depositing and patterning the first contact-making lines (10) in the first dielectric layer (6) in a memory cell array of a semiconductor substrate;
(b) depositing and patterning the magnetoresistive memory components (11) in the memory cell array;
(c) depositing and patterning the diffusion barrier layer (15; 22, 7) in the memory cell array;
(d) self-aligned contact-making with the semiconductor components (11) by etching back the hard mask (12) by which the patterning of the memory components (11) is defined,
(e) depositing and patterning the second contact-making lines (20, 29, 35) in the second dielectric layer (17, 27, 32) in the memory cell array.

## Revendications

1. Dispositif à cellules de mémoire
avec un champ de cellules de mémoire qui comporte au moins une strate d'éléments de mémoire magnétorésistifs (11) avec au moins deux couches ferromagnétiques,
qui sont raccordées respectivement à des premières lignes de contact (10), les premières lignes de contact (10) étant en cuivre et se trouvant à l'intérieur d'une première couche diélectrique (6), et
qui sont raccordées respectivement à des deuxièmes lignes de contact (20 ; 29 ; 35), les deuxièmes lignes de contact (20 ; 29 ; 35) étant en cuivre et se trouvant à l'intérieur d'une deuxième couche diélectrique (17 ; 27 ; 32),
**caractérisé par le fait que**
une couche de barrière de diffusion (15 ; 22 ; 7 ; 31) en nitrure de silicium, qui entoure de manière adjacente les éléments de mémoire (11) est prévue entre les premières lignes de contact (10) et la deuxième couche diélectrique (17 ; 27 ; 32),
la couche de barrière de diffusion (15 ; 22 ; 7 ; 31) empêchant la diffusion de cuivre des premières lignes de contact (10) vers la deuxième couche diélectrique (17 ; 27 ; 32) et vers les éléments de mémoire magnétorésistifs (11), et
la couche de barrière de diffusion (15 ; 22 ; 7 ; 31) empêchant l'interdiffusion entre les couches ferromagnétiques (11b, 11d) des éléments de mémoire magnétorésistifs (11) et les premières lignes de contact (10) pour minimiser la dérive de mémoire.

2. Dispositif à cellules de mémoire selon la revendication 1,
**caractérisé par le fait que** les éléments de mémoire (11) sont des éléments de mémoire TMR qui comportent respectivement deux couches ferromagnétiques (11b, 11d) et une couche isolante non magnétique (11c) située entre les deux couches ferromagnétiques (11b, 11d).

3. Dispositif à cellules de mémoire selon la revendication 1,
**caractérisé par le fait que** les éléments de mémoire (11) sont des éléments de mémoire GMR qui comportent respectivement deux couches ferromagnétiques (11b, 11d) et une couche conductrice non magnétique (11c) située entre les deux couches ferromagnétiques (11b, 11d).

4. Dispositif à cellules de mémoire selon l'une des revendications précédentes,
**caractérisé par le fait que** les éléments de mémoire (11) sont raccordés respectivement aux lignes de contact (10 ; 20 ; 29 ; 35) par l'intermédiaire de couches de barrière de diffusion de contact (11a, 11e).

5. Dispositif à cellules de mémoire selon l'une des revendications précédentes,
**caractérisé par le fait que** les couches de barrière de diffusion de contact (11a, 11e) sont en tantale.

6. Dispositif à cellules de mémoire selon l'une des revendications précédentes,
**caractérisé par le fait que** les premières lignes de contact (10) sont séparées, par une deuxième couche de barrière de diffusion (5) et un liner (9), d'une troisième couche diélectrique (4) qui est placée sur un substrat semi-conducteur (1).

7. Dispositif à cellules de mémoire selon l'une des revendications précédentes,
**caractérisé par le fait que** les couches diélectriques sont en dioxyde de silicium.

8. Procédé de fabrication d'un dispositif à cellules de mémoire selon la revendication 1 avec les étapes suivantes :
(a) déposer et structurer les premières lignes de contact (10) dans la première couche diélectrique (6) dans un champ de cellules de mémoire d'un substrat semi-conducteur ;
(b) déposer et structurer les éléments de mémoire magnétorésistifs (11) dans le champ de cellules de mémoire ;
(c) déposer et structurer la couche de barrière de diffusion (15 ; 22, 7) dans le champ de cellules de mémoire ;
(d) mettre en contact avec auto-ajustage les éléments de mémoire (11) par gravure en retrait du masque dur (12) par lequel la structuration des éléments de mémoire (11) est définie ;
(e) déposer et structurer les deuxièmes lignes de contact (20, 29, 35) dans la deuxième couche diélectrique (17, 27, 32) dans le champ de cellules de mémoire.
